# EUROPEAN PATENT APPLICATION

(11) **EP 4 506 999 A1**
(43) Date of publication of application: **12.02.2025**
(21) Application number: 24193455.3
(22) Date of filing: 07.08.2024
(51) Int. Cl.: H01L 25/075

(54) **MICRO LED PIXEL AND MICRO LED ARRAY PANEL**

(30) Priority: 10.08.2023 WO PCT/CN2023/112261
(71) Applicant: Jade Bird Display (Shanghai) Limited, Shanghai 201306 (CN)
(72) Inventor: XU, Qunchao, Shangai (CN); TAN, Weisin, Shanghai (CN)
(74) Representative: Finnegan Europe LLP

(57) **Abstract**

A micro LED pixel includes three light emitting mesas including a first light emitting mesa, a second light emitting mesa, and a third light emitting mesa. At least parts of at least two light emitting mesas of the three light emitting mesas are overlapped, and at least part of the second light emitting mesa does not cover the first light emitting mesa or at least part of the third light emitting mesa does not cover the first light emitting mesa or the second light emitting mesa, the first light emitting mesa, the second light emitting mesa, and the third light emitting mesa do not contact with each other.

## Description

### CROSS-REFERENCE TO RELATED APPLICATIONS

The present disclosure claims the benefits of priority to PCT Application No. PCT/CN2023/112261, filed on August 10, 2023, which is incorporated herein by reference in its entirety.

### TECHNICAL FIELD

The present disclosure generally relates to micro display technology, and more particularly, to a micro light emitting diode (LED) and a micro LED array panel.

### BACKGROUND

Generally, a traditional micro LED pixel includes three or more micro LED mesas disposed side by side to form a micro LED panel. The three or more micro LEDs mesas may emit different color light.

To reduce a volume of a micro LED pixel, the micro LED pixel may include several micro LED mesas formed vertically with a common central axis. The micro LED mesas define a light emitting area, and electrodes for the micro LED mesas are formed on an external panel outside the light emitting area of the micro LED pixel. However, the external panel may increase the dimensions of a micro LED pixel.

Therefore, the micro LED pixel structure needs to be further improved to reduce its dimension and increase the light emitting area.

### SUMMARY OF THE DISCLOSURE

Embodiments of the present disclosure provide a micro LED pixel. The micro LED pixel includes three light emitting mesas comprising a first light emitting mesa, a second light emitting mesa, and a third light emitting mesa, wherein at least parts of at least two light emitting mesas of the three light emitting mesas are overlapped, and at least part of the second light emitting mesa does not cover the first light emitting mesa or at least part of the third light emitting mesa does not cover the first light emitting mesa or the second light emitting mesa, the first light emitting mesa, the second light emitting mesa, and the third light emitting mesa do not contact with each other.

Embodiments of the present disclosure provide a micro LED array panel. The micro LED array panel includes a plurality of micro LED pixels described above, wherein the plurality of micro LED pixels are provided in an array.

Embodiments of the present disclosure provide a micro LED array panel. The micro LED array panel includes a plurality of micro LED pixels described above, wherein the micro LED pixel further includes a top conductive layer continuously formed on top surfaces of the first light emitting mesa, the second light emitting mesa, and the third light emitting mesa, and respective top conductive layers of the plurality of micro LED pixels are interconnected.

Embodiments of the present disclosure provide a micro LED array panel. The micro LED array panel includes a plurality of micro LED pixels described above, wherein the micro LED pixel further includes an integrated circuit (IC) backplane provided at a bottom of the micro LED pixel, and respective IC backplanes of the plurality of micro LED pixels are interconnected.

### BRIEF DESCRIPTION OF THE DRAWINGS

Embodiments and various aspects of the present disclosure are illustrated in the following detailed description and the accompanying figures. Various features shown in the figures are not drawn to scale.
**FIG. 1** illustrates a structural diagram showing an example micro LED pixel, according to some embodiments of the present disclosure.
**FIG. 2** illustrates a structural diagram showing a top view of the micro LED pixel shown in **FIG. 1****,** according to some embodiments of the present disclosure.
**FIG. 3** illustrates a structural diagram showing a sectional view of the micro LED pixel along an A-A' direction shown in **FIG. 2****,** according to some embodiments of the present disclosure.
**FIG. 4** illustrates a structural diagram showing a sectional view of the micro LED pixel along a B-B' direction shown in **FIG. 2****,** according to some embodiments of the present disclosure.
**FIG. 5** illustrates a structural diagram showing a sectional view of the micro LED pixel along a C-C' direction shown in **FIG. 2****,** according to some embodiments of the present disclosure.
**FIG. 6** illustrates a structural diagram showing a sectional view of the micro LED pixel structure along a D-D' direction shown in **FIG. 2****,** according to some embodiments of the present disclosure.
**FIG. 7** illustrates a structural diagram showing a top view of an example micro LED array panel, according to some embodiments of the present disclosure.
**FIG. 8** illustrates a structural diagram showing another top view of the example micro LED array panel shown in **FIG. 7** with a top conductive layer and a top contacting structure removed from the view, according to some embodiments of the present disclosure.
**FIG. 9** illustrates a structural diagram showing a sectional view of the micro LED array panel along an E-E' direction shown in **FIG. 7****,** according to some embodiments of the present disclosure.
**FIG. 10** illustrates a structural diagram showing a sectional view of the micro LED array panel along an F-F' direction shown in **FIG. 7****,** according to some embodiments of the present disclosure.
**FIG. 11** to **FIG. 17** respectively illustrate a structural diagram showing a top view of different example micro LED pixels, according to some embodiments of the present disclosure.

### DETAILED DESCRIPTION

Reference will now be made in detail to exemplary embodiments, examples of which are illustrated in the accompanying drawings. The following description refers to the accompanying drawings in which the same numbers in different drawings represent the same or similar elements unless otherwise represented. The implementations set forth in the following description of exemplary embodiments do not represent all implementations consistent with the invention. Instead, they are merely examples of apparatuses and methods consistent with aspects related to the invention as recited in the appended claims. Particular aspects of the present disclosure are described in greater detail below. The terms and definitions provided herein control, if in conflict with terms and/or definitions incorporated by reference.

Embodiments of the present disclosure provide a micro LED pixel with light emitting mesas staggered to reduce one or more cross-sectional dimensions of the micro LED pixel.

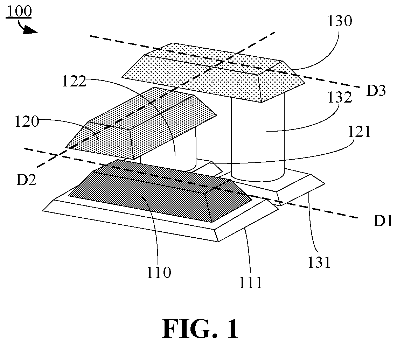

**FIG. 1** illustrates a structural diagram showing an example micro LED pixel 100, according to some embodiments of the present disclosure. As shown in **FIG. 1****,** micro LED pixel 100 includes three light emitting mesas staggered and spaced apart in a vertical direction. For example, a first light emitting mesa 110 is provided at a bottom-most position, a second light emitting mesa 120 is provided above first light emitting mesa 110, and a third light emitting mesa 130 is provide above second light emitting mesa 120. A top surface of first light emitting mesa 110 is lower than a bottom surface of second light emitting mesa 120, and a top surface of second light emitting mesa 120 is lower than a bottom surface of third light emitting mesa 130. That is, first light emitting mesa 110, second light emitting mesa 120 and third light emitting mesa 130 are spaced apart, i.e., they do not contact each other.

At least part of the three light emitting mesas may overlap, as viewed from above micro LED pixel 100. For example, at least part of second light emitting mesa 120 covers, i.e., overlaps without contacting, at least part of first light emitting mesa 110, or at least part of third light emitting mesa 130 covers, i.e., overlaps without contacting, at least part of first light emitting mesa 110 or second light emitting mesa. At the same time, another part of second light emitting mesa 120 does not cover first light emitting mesa 110, or another part of third light emitting mesa 130 does not cover second light emitting mesa 120 or first light emitting mesa 110. Referring to **FIG. 1****,** in this example, a part of third light emitting mesa 130 covers a part of second light emitting mesa 120 and a part of second light emitting mesa 120 covers a part of first light emitting mesa 110. The other part of first light emitting mesa 110 is not covered by second light emitting mesa 120 or third light emitting mesa 130, and the other part of second light emitting mesa 120 is not covered by third light emitting mesa 130.

Each light emitting mesa (i.e., 110, 120, and 130) includes a top electrode and a bottom electrode. For example, the top electrode is provided at a top surface of the light emitting mesa, and the bottom electrode is provided at a bottom surface of the light emitting mesa. In some embodiments, micro LED pixel 100 further includes a group of conductive bottom pads. As shown in **FIG. 1****,** a group of conductive bottom pads include a first bottom pad 111 of first light emitting mesa 110 provided under first light emitting mesa 110, a second bottom pad 121 of second light emitting mesa 120 provided under the part of second light emitting mesa 120 where second light emitting mesa 120 does not cover first light emitting mesa 110, and a third bottom pad 131 of third light emitting mesa 130 provided under the part of third light emitting mesa 130 where third light emitting mesa 130 does not cover second light emitting mesa 120 or first light emitting mesa 110. That is, second bottom pad 121 is provided under part of second light emitting mesa 120 and is not covered by first light emitting mesa 110. Third bottom pad 131 is provided under part of third light emitting mesa 130 and is not covered by first light emitting mesa 110 or second light emitting mesa 120. First bottom pad 111, second bottom pad 121, and third bottom pad 131 do not contact each other. In some embodiments, micro LED pixel 100 further includes an integrated circuit (IC) backplane (not shown in **FIG. 1**), and first bottom pad 111, second bottom pad 121, and third bottom pad 131 are provided on the IC backplane separately.

Therefore, each light emitting mesa can be connected to a bottom pad under its own bottom surface. For micro LED pixel 100, all the bottom pads can be provided under a light emitting area which is formed by first light emitting mesa 110, second light emitting mesa 120, and third light emitting mesa 130. Therefore, there is no external area required for the bottom pads, and since at least parts of the three emitting mesas are overlapped, the cross-sectional dimensions of micro LED pixel 100 are reduced.

In some embodiments, micro LED pixel 100 includes one or more bottom electrical connecting structures to conductively connect a bottom electrode on the bottom surface of a light emitting mesa to a conductive bottom pad. For example, a first bottom electrical connecting structure may be provided to connect the bottom surface of first light emitting mesa 110 to first bottom pad 111. In this example, since first light emitting mesa 110 is provided at a bottom-most position, the first bottom electrical connecting structure can be a bottom bonding layer or a bottom via provided between the bottom surface of first light emitting mesa 110 and first bottom pad 111 to connect first light emitting mesa 110 and first bottom pad 111. A second bottom electrical connecting structure 122 is provided to connect the bottom surface of second light emitting mesa 120 to second bottom pad 121. A third bottom electrical connecting structure 132 is provided to connect the bottom surface of third light emitting mesa 130 to third bottom pad 131. In some embodiments, second bottom electrical connecting structure 122 and third bottom electrical connecting structure 132 are through vias. A through via is made of metal and may have a hollow structure. Second bottom electrical connecting structure 122 and third bottom electrical connecting structure 132 are not in electrical conductive contact.

In some embodiments, each one of light emitting mesas (i.e., 110, 120, and 130) has a taper structure, that is, an area of a top surface of the light emitting mesa is smaller than an area of a bottom surface of the light emitting mesa, and each light emitting mesa has a symmetrical structure. In some embodiments, the top surface is a rectangle with a width (shorter side) and a length (longer side). The symmetric structure is characterized by a length vertical symmetrical plane along a length direction and a width vertical symmetrical plane along a width direction. The length vertical symmetrical plane is perpendicular to the width vertical symmetrical plane, and an intersection line of the length vertical symmetrical plane and the width vertical symmetrical plane refers to a vertical center line of, and perpendicular to, the light emitting mesa. In some embodiments, the top surface is a square, that is, the width and the length are equal. It can be understood that, in this case, the width direction and the length direction can be interchanged, and can be referred as to a first direction and a second direction. Accordingly, the length vertical symmetrical plane and the width vertical symmetrical plane can be interchanged, and referred as to a first vertical symmetrical plane and a second vertical symmetrical plane.

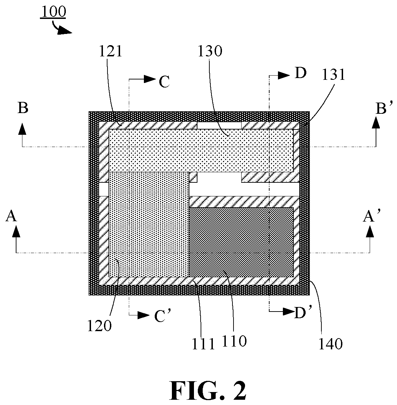

**FIG. 2** illustrates a structural diagram showing a top view of the micro LED pixel shown in **FIG. 1****,** according to some embodiments of the present disclosure. As shown in **FIG. 2****,** consistent with **FIG. 1****,** in this example, a length vertical symmetrical plane of first light emitting mesa 110 and a length vertical symmetrical plane of third light emitting mesa 130 are parallel, and are perpendicular to a length vertical symmetrical plane of second light emitting mesa 120.

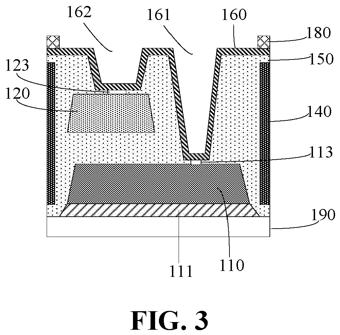

**FIG. 3** to **FIG. 6** illustrate an exemplary structure of micro LED pixel 100, according to some embodiments of the present disclosure.

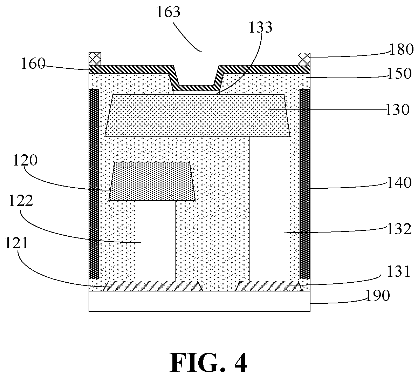

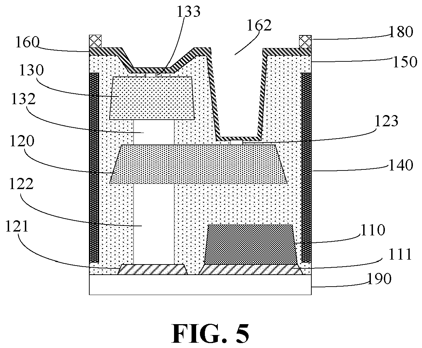

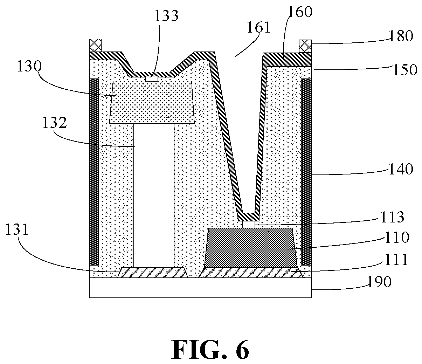

**FIG. 3** illustrates a structural diagram showing a sectional view of micro LED pixel 100 along an A-A' direction shown in **FIG. 2****,** according to some embodiments of the present disclosure. **FIG. 4** illustrates a structural diagram showing a sectional view of micro LED pixel 100 along a B-B' direction shown in **FIG. 2****,** according to some embodiments of the present disclosure. **FIG. 5** illustrates a structural diagram showing a sectional view of micro LED pixel 100 along a C-C' direction shown in **FIG. 2****,** according to some embodiments of the present disclosure. **FIG. 6** illustrates a structural diagram showing a sectional view of micro LED pixel 100 along a D-D' direction shown in **FIG. 2****,** according to some embodiments of the present disclosure.

Referring to **FIG. 3** to **FIG. 6****,** micro LED pixel 100 further includes a top conductive layer 160 formed over a top surface of micro LED pixel 100. As shown in **FIG. 3****,** top conductive layer 160 is continuously formed over first light emitting mesa 110, second light emitting mesa 120, and third light emitting mesa 130, and configured to connect to top electrodes of first light emitting mesa 110, second light emitting mesa 120, and third light emitting mesa 130. Top conductive layer 160 has an undulating structure and includes one or more sunken portions. In some embodiments, top conductive layer 160 includes sunken portions (e.g., 161, 162, and 163) corresponding to each light emitting mesa for connecting to each light emitting mesa respectively. Since three light emitting mesas (i.e., 110, 120, and 130) are at different position in a vertical direction, depths of the three sunken portions (e.g., 161, 162, and 163) are different. In some embodiments, micro LED pixel 100 further includes a top electrical connecting structure (e.g., 113, 123, and 133) for connecting the top electrode of a light emitting mesa to top conductive layer 160. For example, a first top electrical connecting structure 113 is provided on the top surface of first light emitting mesa 110 for connecting to top conductive layer 160. A second top electrical connecting structure 123 is provided on the top surface of second light emitting mesa 120 for connecting to top conductive layer 160. The top electrical connecting structure (e.g., 113, 123, and 133) may serve as an ohmic contact layer. In some embodiments, a material of the top electrical connecting structure (e.g., 113, 123, and 133) is metal. In some embodiments, top conductive layer 160 can contact top surfaces of the three light emitting mesas (i.e., 110, 120, and 130) directly, so that the top electrical connecting structure (e.g., 113, 123, 133) is not required. In some embodiments, top conductive layer 160 is transparent with a light transmittance rate not less than 70%. In some embodiments, top conductive layer 160 is a TCO (transparent conductive oxide) layer, for example, an ITO (Indium Tin Oxide) layer, an AZO (Antimony doped Zinc Oxide) layer, an ATO (Antimony doped Tin Oxide) layer, an FTO (Fluorine doped Tin Oxide) layer, or the like.

In some embodiments, a top contacting structure 180 is provided on top conductive layer 160 and configured to provide a contact for top conductive layer 160. In some embodiments, top contacting structure 180 is connected to a top pad, and for further connection with an external circuit. In some embodiments, the top pad is provided on an IC backplane. In some embodiments, top contacting structure 180 is provided at an edge of micro LED pixel 100 and around a periphery of micro LED pixel 100.

In some embodiments, micro LED pixel 100 further includes an optical isolation structure 140, provided around micro LED pixel 100, configured to prevent light from crossing between adjacent micro LED pixels. In some embodiments, a top of optical isolation structure 140 is equal to or higher than a top surface of third light emitting mesa 130, and a bottom of optical isolation structure 140 is equal to or lower than a bottom surface of first light emitting mesa 110. Therefore, optical isolation structure 140 can prevent light crossing between light emitting mesas of adjacent micro LED pixels. It can be understood that optical isolation structure 140 does not connect with the light emitting mesas (i.e., 110, 120, 130), top conductive layer 160, and an IC backplane 190.

In some embodiments, optical isolation structure 140 is reflective. In some embodiments, a material of optical isolation structure 140 is metal.

In some embodiments, micro LED pixel 100 further includes a dielectric material 150 filled within micro LED pixel 100, that is, dielectric material 150 fills a space at least partly defined by IC backplane 190, top conductive layer 160, and optical isolation structure 140. More specifically, dielectric material 150 fills the space among first light emitting mesa 110, second light emitting mesa 120, third light emitting mesa 130, second bottom electrical connecting structure 122, third bottom electrical connecting structure 132, first bottom pad 111, second bottom pad 121, third bottom pad 131, IC backplane 190, top conductive layer 160, and optical isolation structure 140. In some embodiments, the space defined by IC backplane 190, top conductive layer 160, and optical isolation structure 140 can have a box structure. In some embodiments, dielectric material 150 is selected from one or more of silicon oxide, silicon nitride, SiCN, SiNO, or Al₂O₃. In some embodiments, dielectric material 150 is transparent.

With the structure described above, the micro LED pixel provided by the embodiments of the present disclosure may have a good balance between high transmittance rate and dimension. Because of the staggered arrangement of the light emitting mesas, the bottom connecting electrical structures can be provided under each light emitting mesa with at least part of the light emitting mesas is overlapped. Thus, an external panel for connecting with the electrodes is not required, thereby reducing the cross-sectional dimensions of the micro LED pixel with a higher transmittance rate.

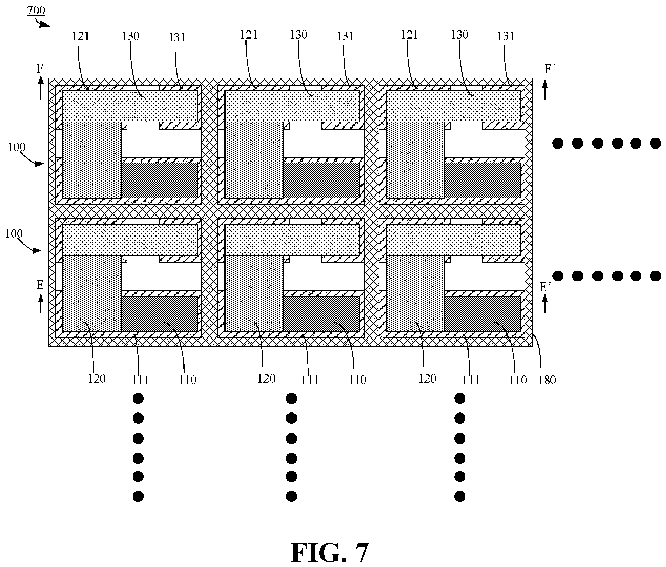

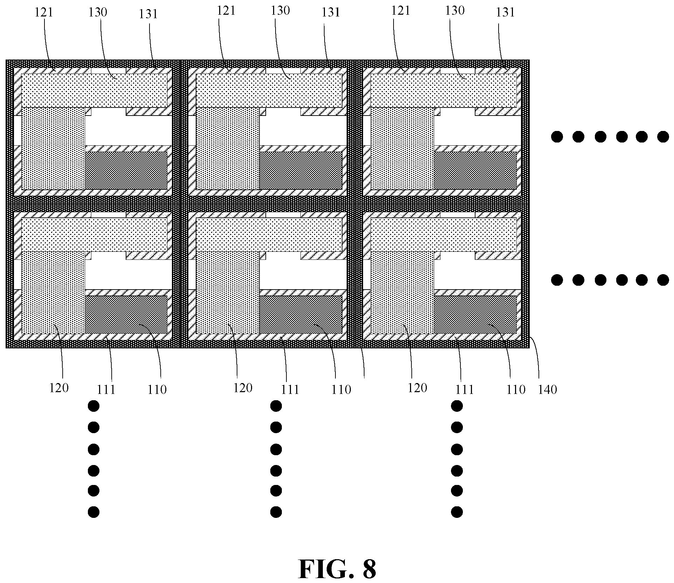

**FIG. 7** illustrates a structural diagram showing a top view of an example micro LED array panel 700, according to some embodiments of the present disclosure. **FIG. 8** illustrates a structural diagram showing another top view of micro LED array panel 700 with top conductive layer 160 and top contacting structure 180 removed, according to some embodiments of the present disclosure. Referring to **FIG. 7** and **FIG. 8****,** micro LED array panel 700 includes two or more micro LED pixels 100 arranged in an array. In this example, a 3×2 array is illustrated. As shown in **FIG. 7****,** a top view of each micro LED pixel 100 can be in a rectangular shape, therefore the two or more micro LED pixel 100 can be tightly arranged.

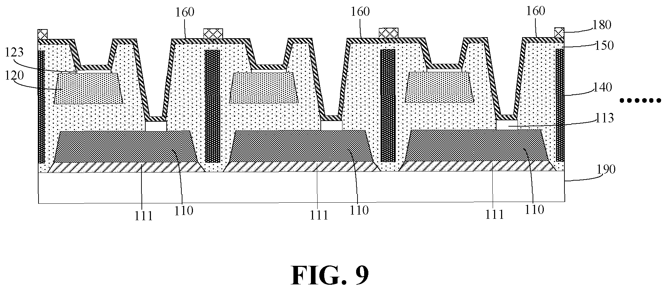

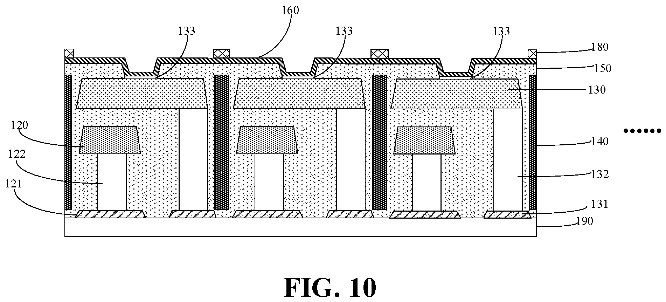

**FIG. 9** illustrates a structural diagram showing a sectional view of micro LED array panel 700 along an E-E' direction shown in **FIG. 7****,** according to some embodiments of the present disclosure. **FIG. 10** illustrates a structural diagram showing a sectional view of micro LED array panel 700 along an F-F' direction shown in **FIG. 7****,** according to some embodiments of the present disclosure. As shown in **FIG. 9** and **FIG. 10****,** light crossing between adjacent micro LED pixels can be prevent by optical isolation structure 140.

Referring to **FIG. 9** and **FIG. 10****,** in some embodiments, respective top conductive layers 160 of the plurality of micro LED pixels 100 are interconnected. For example, top conductive layer 160 is continuously formed on a top of micro LED array panel 700.

In some embodiments, respective IC backplanes 190 of the plurality of micro LED pixels 100 are interconnected. For example, IC backplane 190 may be continuously provided as a whole bottom plate of micro LED array panel 700. In some embodiments, the whole IC backplane 190 further includes a top pad (not shown), and top conductive layer 160 is connected with the top pad. In some embodiments, an external wire is further provided for connecting top contacting structure 180 with the top pad.

Referring back to **FIG. 1****,** in some embodiments, first light emitting mesa 110 is oriented along a first length direction D1, second light emitting mesa 120 is oriented along a second length direction D2, and third light emitting mesa 130 is oriented along a third length direction D3. In some embodiments, a vertical center line of third light emitting mesa 130 and a vertical center line of the second light emitting mesa 120 are not aligned. In this example, a length vertical symmetrical plane of first light emitting mesa 110 and a length vertical symmetrical plane of third light emitting mesa 130 are parallel, and both are perpendicular to a length vertical symmetrical plane of second light emitting mesa 120.

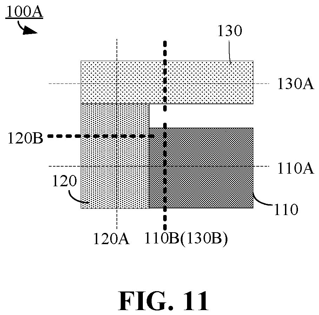

**FIG. 11** to **FIG. 17** respectively illustrate structural diagrams showing top views of different example micro LED pixels, according to various embodiments of the present disclosure. In such various embodiments, first light emitting mesa 110, second light emitting mesa 120, and third light emitting mesa 130 can be arranged in different directions and with different dimension.

Referring to **FIG. 11****,** consistent with the example micro LED pixel shown in **FIG. 1****,** in an example micro LED pixel 100A, a first vertical symmetrical plane 110A of first light emitting mesa 110 and a first vertical symmetrical plane 130A of third light emitting mesa 130 are parallel and perpendicular to a first vertical symmetrical plane 120A of second light emitting mesa 120. A second vertical symmetrical plane 110B of first light emitting mesa 110 is aligned with a second vertical symmetrical plane 130B of third light emitting mesa 130, that is, second vertical symmetrical plane 110B of first light emitting mesa 110 and second vertical symmetrical plane 130B of third light emitting mesa 130 are co-planar. A part of third light emitting mesa 130 covers a part of second light emitting mesa 120 and a part of second light emitting mesa 120 covers a part of first light emitting mesa 110. Another part of first light emitting mesa is not covered by second light emitting mesa 120 or third light emitting mesa 130, and another part of second light emitting mesa 120 is not covered by third light emitting mesa 130. In this example, each light emitting mesa may have a light emitting area facing upward and not covered by the other light emitting mesas. Therefore, the light emitting quality can be high and transmittance rates of the light emitting mesas can be balanced.

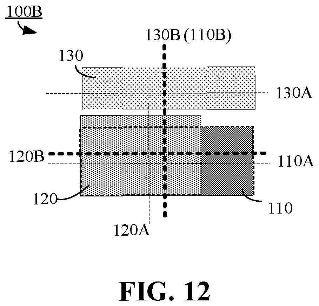

Referring to **FIG. 12****,** in an example micro LED pixel 100B, a part of second light emitting mesa 120 covers a part of first light emitting mesa 110, the other part of second light emitting mesa 120 does not cover first light emitting mesa 110, and the other part of first light emitting mesa 110 is not covered by second light emitting mesa 120. Third light emitting mesa 130 does not cover second light emitting mesa 120 or first light emitting mesa 110. In this example, both second light emitting mesa 120 and third light emitting mesa 130 can emit light without being covered by the other light emitting mesas. More specifically, in **FIG. 12****,** a first vertical symmetrical plane 110A of first light emitting mesa 110 and a first vertical symmetrical plane 130A of third light emitting mesa 130 are parallel and both are perpendicular to a first vertical symmetrical plane 120A of second light emitting mesa 120. A second vertical symmetrical plane 110B of first light emitting mesa 110 is aligned with a second vertical symmetrical plane 130B of third light emitting mesa 130, that is, second vertical symmetrical plane 110B of first light emitting mesa 110 and second vertical symmetrical plane 130B of third light emitting mesa 130 are co-planar. Since third light emitting mesa 130 does not cover second light emitting mesa 120 or first light emitting mesa 110, third light emitting mesa 130 can be provided at any position in a vertical direction, as long as third light emitting mesa 130 does not contact first light emitting mesa 110 or second light emitting mesa 120. For example, third light emitting mesa 130 and second light emitting mesa 120 can be provided in the same plane. Therefore, a height of micro LED pixel 100B can be reduced.

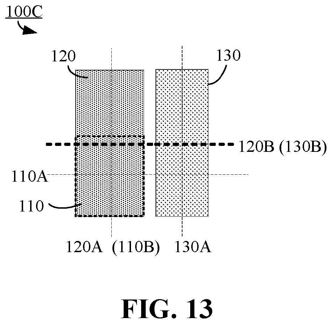

Referring to **FIG. 13****,** in an example micro LED pixel 100C, first light emitting mesa 110 is fully covered by a part of second light emitting mesa 120. The other part of second light emitting mesa 120 does not cover first light emitting mesa 110. Third light emitting mesa 130 does not cover second light emitting mesa 120 or first light emitting mesa 110. More specifically, a first vertical symmetrical plane 120A of second light emitting mesa 120 and a second vertical symmetrical plane 110B of first light emitting mesa 110 are co-planar, and further parallel to a first vertical symmetrical plane 130A of third light emitting mesa 130. A second vertical symmetrical plane 120B of second light emitting mesa 120 and a second vertical symmetrical plane 130B of third light emitting mesa 130 are co-planar, and further parallel to a first vertical symmetrical plane 110A of first light emitting mesa 110. Since third light emitting mesa 130 does not cover second light emitting mesa 120 or first light emitting mesa 110, third light emitting mesa 130 can be provided at any position in a vertical direction, as long as third light emitting mesa 130 does not contact first light emitting mesa 110 or second light emitting mesa 120. For example, third light emitting mesa 130 and second light emitting mesa 120 can be provided in the same plane. Therefore, a height of micro LED pixel 100C can be reduced.

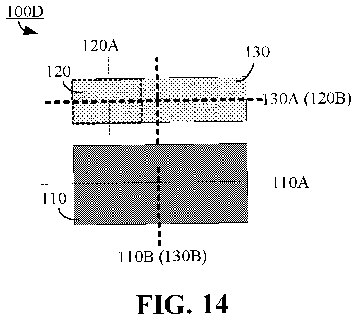

Referring to **FIG. 14****,** in an example micro LED pixel 100D, second light emitting mesa 120 is fully covered by a part of third light emitting mesa 130. The other part of third light emitting mesa 130 does not cover second light emitting mesa 120. First light emitting mesa 110 is not covered by second light emitting mesa 120 or third light emitting mesa 130. First light emitting mesa 110 can emit light without being covered by the other light emitting mesas. More specifically, a first vertical symmetrical plane 130A of third light emitting mesa 130 and a second vertical symmetrical plane 120B of second light emitting mesa 120 are co-planar, and further parallel to a first vertical symmetrical plane 110A of first light emitting mesa 110. A second vertical symmetrical plane 110B of first light emitting mesa 110 and a second vertical symmetrical plane 130B of third light emitting mesa 130 are co-planar, and further parallel to a first vertical symmetrical plane 120A of second light emitting mesa 120. Since first light emitting mesa 110 is not covered by second light emitting mesa 120 or third light emitting mesa 130, first light emitting mesa 110 can be provided at any position in a vertical direction, as long as first light emitting mesa 110 does not contact second light emitting mesa 120 or third light emitting mesa 130. For example, first light emitting mesa 110 and second light emitting mesa 120 can be provided in the same plane. Therefore, a height of micro LED pixel 100D can be reduced.

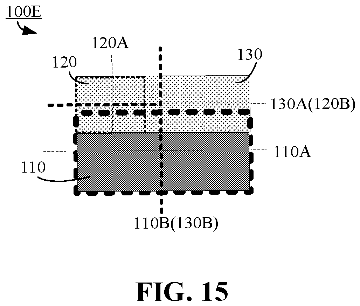

Referring to **FIG. 15****,** in an example micro LED pixel 100E, second light emitting mesa 120 is fully covered by a part of third light emitting mesa 130, and a part of second light emitting mesa 120 covers a part of first light emitting mesa 110. A part of third light emitting mesa 130 also covers a part of first light emitting mesa 110. More specifically, a first vertical symmetrical plane 130A of third light emitting mesa 130 and a second vertical symmetrical plane 120B of second light emitting mesa 120 are co-planar, and further parallel to a first vertical symmetrical plane 110A of first light emitting mesa 110. A second vertical symmetrical plane 110B of first light emitting mesa 110 and a second vertical symmetrical plane 130B of third light emitting mesa 130 are co-planar, and further parallel to a first vertical symmetrical plane 120A of second light emitting mesa 120.

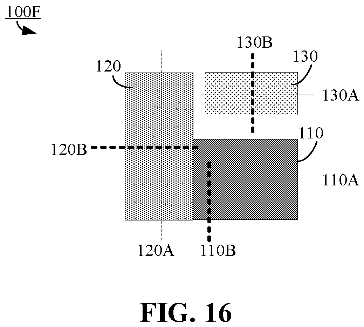

Referring to **FIG. 16****,** in an example micro LED pixel 100F, third light emitting mesa 130 does not cover any part of second light emitting mesa 120 or first light emitting mesa 110. A part of second light emitting mesa 120 covers a part of first light emitting mesa 110. More specifically, a first vertical symmetrical plane 110A of first light emitting mesa 110 and a first vertical symmetrical plane 130A of third light emitting mesa 130 are parallel and perpendicular to a first vertical symmetrical plane 120A of second light emitting mesa 120. A second vertical symmetrical plane 110B of first light emitting mesa 110 and a second vertical symmetrical plane 130B of third light emitting mesa 130 are parallel and perpendicular to a second vertical symmetrical plane 120B of second light emitting mesa 120. Comparing with micro LED pixel 100B shown in **FIG. 12****,** in this example, an emitting area of third light emitting mesa 130 is reduced, and emitting area of first light emitting mesa 110 is increased. Since third light emitting mesa 130 does not cover second light emitting mesa 120 or first light emitting mesa 110, third light emitting mesa 130 can be provided at any position in a vertical direction, as long as third light emitting mesa 130 does not contact first light emitting mesa 110 or second light emitting mesa 120. For example, third light emitting mesa 130 and second light emitting mesa 120 can be provided in the same plane. Therefore, a height of micro LED pixel 100F can be reduced.

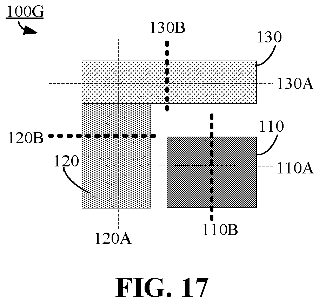

Referring to **FIG. 17****,** in an example micro LED pixel 100G, a part of third light emitting mesa 130 covers a part of second light emitting mesa 120. First light emitting mesa 110 is not covered by second light emitting mesa 120 or third light emitting mesa 130. More specifically, a first vertical symmetrical plane 110A of first light emitting mesa 110 and a first vertical symmetrical plane 130A of third light emitting mesa 130 are parallel and perpendicular to a first vertical symmetrical plane 120A of second light emitting mesa 120. A second vertical symmetrical plane 110B of first light emitting mesa 110 and a second vertical symmetrical plane 130B of third light emitting mesa 130 are parallel and perpendicular to a second vertical symmetrical plane 120B of second light emitting mesa 120. Comparing with micro LED pixel 100D shown in **FIG. 14****,** an emitting area of first light emitting mesa 110 is reduced, while an emitting area of second light emitting mesa 120 is increased. Comparing with micro LED pixel 100F shown in **FIG. 16****,** an emitting area of second light emitting mesa 120 is reduced, while an emitting area of third light emitting mesa 130 is increased. Since first light emitting mesa 110 is not covered by second light emitting mesa 120 or third light emitting mesa 130, first light emitting mesa 110 can be provided at any position in a vertical direction, as long as first light emitting mesa 110 does not contact second light emitting mesa 120 or third light emitting mesa 130. For example, first light emitting mesa 110 and second light emitting mesa 120 can be provided in the same plane. Therefore, a height of micro LED pixel 100G can be reduced.

In some embodiments, an area of the top surface of the bottom-most light emitting mesa is the largest among areas of the three or more light emitting mesas. In this example, an area of the top surface of first light emitting mesa 110 is larger than an area of the top surface of second light emitting mesa 120 and an area of the top surface of third light emitting mesa 130.

In some embodiments, the three or more light emitting mesa include at least a red light emitting mesa configured to emit red light, a green light emitting mesa configured to emit green light, and a blue light emitting mesa configured to emit blue light. For example, first light emitting mesa 110 is the red light emitting mesa, second light emitting mesa 120 is the green light emitting mesa, and third light emitting mesa 130 is the blue light emitting mesa. In some embodiments, first light emitting mesa 110 is the red light emitting mesa, second light emitting mesa 120 is the blue light emitting mesa, and third light emitting mesa 130 is the green light emitting mesa.

It can be understood by those skilled in the art that there are many other arrangements for these three or more light emitting mesas. The purpose for the arrangements is that each light emitting mesa can be connected to the electrode under the light emitting mesa itself without requirement of external panel. Thus, cross-sectional dimensions of the micro LED pixel can be reduced. In some embodiments, the arrangement of the three or more light emitting mesas forms a rectangular top surface. Therefore, the micro LED pixels provided by the embodiments of the present disclosure are convenient for assembling a micro LED array panel with a large light emitting area.

It should be noted that, the relational terms herein such as "first" and "second" are used only to differentiate an entity or operation from another entity or operation, and do not require or imply any actual relationship or sequence between these entities or operations. Moreover, the words "comprising," "having," "containing," and "including," and other similar forms are intended to be equivalent in meaning and be open ended in that an item or items following any one of these words is not meant to be an exhaustive listing of such item or items, or meant to be limited to only the listed item or items.

As used herein, unless specifically stated otherwise, the term "or" encompasses all possible combinations, except where infeasible. For example, if it is stated that a database may include A or B, then, unless specifically stated otherwise or infeasible, the database may include A, or B, or A and B. As a second example, if it is stated that a database may include A, B, or C, then, unless specifically stated otherwise or infeasible, the database may include A, or B, or C, or A and B, or A and C, or B and C, or A and B and C.

In the foregoing specification, embodiments have been described with reference to numerous specific details that can vary from implementation to implementation. Certain adaptations and modifications of the described embodiments can be made. Other embodiments can be apparent to those skilled in the art from consideration of the specification and practice of the invention disclosed herein. It is intended that the specification and examples be considered as exemplary only, with a true scope and spirit of the invention being indicated by the following claims. It is also intended that the sequence of steps shown in figures are only for illustrative purposes and are not intended to be limited to any particular sequence of steps. As such, those skilled in the art can appreciate that these steps can be performed in a different order while implementing the same method.

In the drawings and specification, there have been disclosed exemplary embodiments. However, many variations and modifications can be made to these embodiments. Accordingly, although specific terms are employed, they are used in a generic and descriptive sense only and not for purposes of limitation.

## Claims

1. A micro LED pixel, comprising:
three light emitting mesas comprising a first light emitting mesa, a second light emitting mesa, and a third light emitting mesa, wherein at least parts of at least two light emitting mesas of the three light emitting mesas are overlapped, and at least part of the second light emitting mesa does not cover the first light emitting mesa or at least part of the third light emitting mesa does not cover the first light emitting mesa or the second light emitting mesa, the first light emitting mesa, the second light emitting mesa, and the third light emitting mesa do not contact with each other.

2. The micro LED pixel according to claim 1, wherein the second light emitting mesa is provided above the first light emitting mesa and the third light emitting mesa is provided above the second light emitting mesa; a part of the third light emitting mesa covers the second light emitting mesa, and the other part of the third light emitting mesa does not cover the second light emitting mesa or the first light emitting mesa.

3. The micro LED pixel according to claim 2, wherein at least part of the second light emitting mesa covers at least part of the first light emitting mesa or wherein the second light emitting mesa does not cover the first light emitting mesa.

4. The micro LED pixel according to claim 2, wherein each of the first light emitting mesa, the second light emitting mesa, and the third light emitting mesa has a symmetric structure, **characterized by**:
a first vertical symmetrical plane along a length direction;
a second vertical symmetrical plane along a width direction; and
a vertical center line that is an intersection line of the first vertical symmetrical plane and the second vertical symmetrical plane, wherein top surfaces of the first light emitting mesa, the second light emitting mesa, and the third light emitting mesa are optionally rectangular.

5. The micro LED pixel according to claim 4, wherein the vertical center line of the third light emitting mesa and the vertical center line of the second light emitting mesa are not aligned.

6. The micro LED pixel according to claim 4, wherein neither the first vertical symmetrical plane nor the second vertical symmetrical plane of the third light emitting mesa is co-planar with the first vertical symmetrical plane and the second vertical symmetrical plane of the second light emitting mesa, wherein the first vertical symmetrical plane of the third light emitting mesa is optionally parallel to the first vertical symmetrical plane of the second light emitting mesa.

7. The micro LED pixel according to claim 4, wherein the first vertical symmetrical plane of the third light emitting mesa is co-planar with the first vertical symmetrical plane of the second light emitting mesa.

8. The micro LED pixel according to claim 2, further comprising an integrated circuit (IC) backplane, wherein a first bottom pad, a second bottom pad, and a third bottom pad are separately provided on the IC backplane and configured to connect to bottom electrodes of the first light emitting mesa, the second light emitting mesa, and the third light emitting mesa, respectively, the micro LED pixel optionally comprising a top conductive layer continuously formed over top surfaces of the first light emitting mesa, the second light emitting mesa, and the third light emitting mesa, and configured to connect to top electrodes of the first light emitting mesa, the second light emitting mesa, and the third light emitting mesa, wherein the top conductive layer optionally comprises one or more sunken portions to connect to the first light emitting mesa, the second light emitting mesa, and the third light emitting mesa, respectively, the top conductive layer being optionally transparent with a light transmittance rate not less than 70%.

9. The micro LED pixel according to claim 8, further comprising a top contacting structure provided on the top conductive layer and configured to provide a contact for the top conductive layer, wherein the top contacting structure is optionally provided at a periphery of the micro LED pixel.

10. The micro LED pixel according to claim 8, further comprising an optical isolation structure formed around the micro LED pixel, wherein the optical isolation structure is optionally reflective and/or a material of the optical isolation structure is metal.

11. The micro LED pixel according to claim 10, wherein the optical isolation structure does not contact the top conductive layer, the first light emitting mesa, the second light emitting mesa, the third light emitting mesa, the bottom pads, or the IC backplane.

12. The micro LED pixel according to claim 10, further comprising a dielectric material filled in a space within the micro LED pixel, wherein the dielectric material is optionally selected from one of silicon oxide, silicon nitride, SiCN, SiNO, or Al₂O₃ and/or optionally transparent.

13. The micro LED pixel according to claim 2, wherein an area of a top surface of the first light emitting mesa is greater than an area of a top surface of the second light emitting mesa and greater than an area of a top surface of the third light emitting mesa.

14. The micro LED pixel according to claim 1, wherein the first light emitting mesa is configured to emit red light, the second light emitting mesa is configured to emit green light, and the third light emitting mesa is configured to emit blue light, or wherein the first light emitting mesa is configured to emit red light, the second light emitting mesa is configured to emit blue light, and the third light emitting mesa is configured to emit green light.

15. A micro LED array panel, comprising:
a plurality of micro LED pixels according to any one of claims 1 to 14, wherein the plurality of micro LED pixels are provided in an array.

16. A micro LED array panel, comprising:
a plurality of micro LED pixels according to any one of claims 1-14, wherein the plurality of micro LED pixels are provided in an array, and
wherein the micro LED pixel further comprises a top conductive layer continuously formed on top surfaces of the first light emitting mesa, the second light emitting mesa, and the third light emitting mesa, and respective top conductive layers of the plurality of micro LED pixels are interconnected.

17. A micro LED array panel, comprising:
a plurality of micro LED pixels according to any one of claims 1-14, wherein the plurality of micro LED pixels are provided in an array, and
wherein the micro LED pixel further comprises an integrated circuit (IC) backplane provided at a bottom of the micro LED pixel, and respective IC backplanes of the plurality of micro LED pixels are interconnected.
